# EUROPEAN PATENT APPLICATION

(11) **EP 1 403 689 A2**
(43) Date of publication of application: **31.03.2004**
(21) Application number: 03103418.4
(22) Date of filing: 17.09.2003
(51) Int. Cl.: G02F 1/13357, C09K 11/08

(54) **Backlight for a color LCD using wavelength convertion of the light emitted by a light source**

(30) Priority: 27.09.2002 US 256706
(71) Applicant: Lumileds Lighting U.S., LLC, San Jose, California 95131 (US)
(72) Inventor: Lowery, Christopher H. Lumileds Lighting U.S.,LLC, San Jose 95131 (US); Timmers, Wilhelmus A. G. Lumileds Lighting U.S.LLC, San Jose 95131 (US); Sillevis Smitt, Johannes W. H. Lumileds Lighting, San Jose 95131 (US)
(74) Representative: van der Veer, Johannis Leendert

(57) **Abstract**

A backlight for an LCD uses as a light source at least one red light source, at lest one green light source, at least one blue light source, wherein one of the sources comprises a light emitting diode capable of emitting light at a first wavelength and a wavelength-converting material capable of absorbing light of the first wavelength and emitting light of a second wavelenght. In some embodiments, the wavelength-converting material is a strontium thiogallate phosphor or a nitridosilicate phosphor. In some embodiments, the first wavelength is about the same as light emitted by the blue light source, or is barely visible to the human eye.

## Description

### BACKGROUND

### FIELD OF INVENTION

The present invention is directed to a color, transmissive LCD that requires backlighting, where the backlighting contains red, green, and blue components.

### DESCRIPTION OF RELATED ART

Liquid crystal displays (LCDs) are commonly used in battery operated equipment, such as cell phones, personal digital assistants (PDAs), and laptop computers, and as replacements for bulky CRTs in television screens and computer monitors. Presently, drawbacks of such LCDs include use of mercury, limited color gamut, and poor efficiency at lower brightness. LCDs can be monochrome or color and can be transmissive or reflective. The present invention deals with a color, transmissive or reflective LCD that requires backlighting.

### SUMMARY

In accordance with embodiments of the present invention, a backlight for an LCD uses as a light source at least one red light source, at least one green light source, and at least one blue light source, wherein one of the red, green, and blue light sources comprises a light emitting diode capable of emitting light at a first wavelength and a wavelength-converting material capable of absorbing light of the first wavelength and emitting light at a second wavelength. In some embodiments, the green light source comprises a light emitting diode capable of emitting light at a first wavelength and a wavelength-converting material capable of absorbing light of the first wavelength and emitting green light. The wavelength-converting material is a strontium thiogallate phosphor or a nitridosilicate phosphor. In some embodiments, the first wavelength is about the same as light emitted by the blue light source, or is barely visible to the human eye.

The use of a wavelength-converted light emitting diode as a green light source in an LCD may offer several advantages. First, since the wavelength-converting material emits light at the same wavelength for a range of pump wavelengths, the color saturation of the LCD can be maintained without the need for each LED to emit the same color light. Second, the color of light emitted by the wavelength-converting material does not vary greatly with temperature or driving current.

### BRIEF DESCRIPTION OF THE DRAWINGS

Fig. 1 is a cross sectional view of a portion of an LCD.
Fig. 2 illustrates a packaged wavelength-converted light emitting device.
Fig. 3 is a cross sectional view of a wavelength-converted light emitting device.

### DETAILED DESCRIPTION

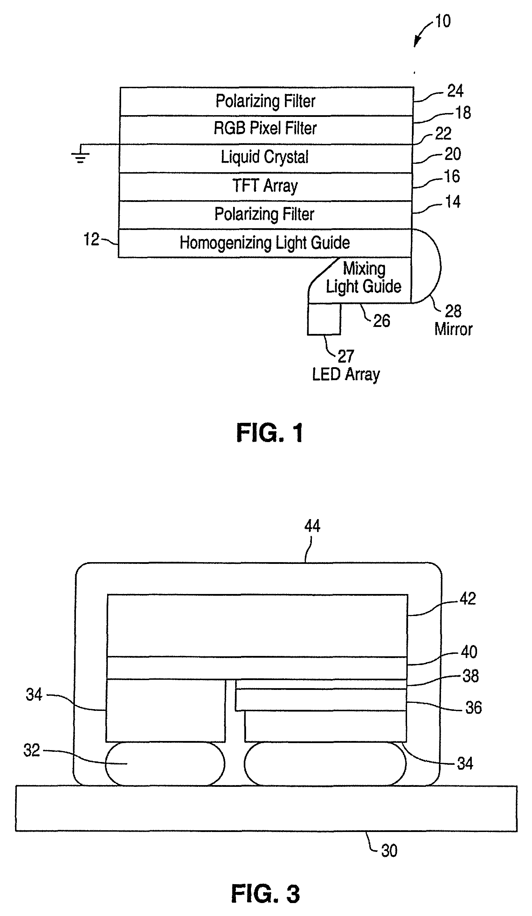

Fig. 1 is a cross sectional view of a portion of a color, transmissive LCD according to an embodiment of the present invention. LCD 10 includes an array 27 of red, blue, and green light emitting diodes for providing backlight to the LCD. The number of LEDs in the array depends on the size of the display and the required brightness. Often, the array will have more green LEDs than red LEDs, and more red LEDs than blue LEDs. In some embodiments, a single light source may generate more than one color of light. In some embodiments, more than three colors of light may be used. The wavelengths of the light sources are chosen to maximize the viewing experience which may include transmission characteristics of color filters used in the system.

The LEDs in array 27 may be arranged, for example, in a line along an edge of mixing light guide 26, which is optically coupled to one edge of the display. If high brightness is required, additional arrays 27 and mixing light guides 26 may be provided on other edges of the display. The light produced by the array of light emitting diodes must be mixed such that the combined light appears white. LED array 27 is coupled to a mixing light guide 26. The mixed light is reflected by a mirror 28 into a light guide 12. A suitable structure for mixing LED light in an LCD is described in "Collimator Cavity Design For LCD Backlight With LEDs," filed in the European Patent Office on June 1, 2001, Application No. 01202137.4, and Gerard Harbers, Wim Timmers, Willem Sillevis-Smitt, "LED Backlighting for LCD-HDTV" in Proceedings of The 2nd International Display Manufacturing Conference, Jin Jang (Editor), p. 181-184, Seoul, Korea, Jan 2002 ISSN 1229-8859 both of which are incorporated herein by reference.

Homogenous white light must be provided to the back surface of the display. A popular technique for providing such homogenous white light is to optically couple the mixed light from the LED array to a light guide 12, such as by optically coupling output of the mixing light guide to one or more edges of a sheet of clear plastic. The sheet has deformities that bend the light approximately normal to the top surface of the sheet so that light is emitted from the surface. Examples of such deformities include ridges in the bottom surface, reflective particles embedded in the plastic sheet, or a roughening of the top or bottom surface of the sheet. The deformities cause a quasi-uniform plane of light to be emitted out the front surface of the light guide. A non-specular reflector may be placed behind the back surface of the light guide to improve brightness and uniformity.

LCD 10 includes two sheets of glass separated by liquid crystal layer 20. The glass sheet closest to LED array 27 includes a polarizing filter 14 and TFT array 16. Polarizing filter 14 linearly polarizes the white light. The polarized white light is then transmitted to a transparent thin film transistor (TFT) array 16 having one transistor for each pixel. TFT arrays are extremely well known.

Above TFT array 16 is a liquid crystal layer 20, and above the liquid crystal layer 20 is a transparent conductive layer 22 connected to ground. The absence of an electrical field across a pixel area of the liquid crystal layer 20 causes light passing through that pixel area to have its polarization rotated orthogonal to the incoming polarization. An electrical field across a pixel area of the liquid crystal layer 20 causes the liquid crystals to align and not affect the polarity of light. Selectively energizing the transistors controls the localized electrical fields across the liquid crystal layer 20. Both normally open (white) and normally closed (black) shutters are used in different displays.

The glass sheet furthest from LED array 27 includes an RGB filter 18 and a polarizing filter 24. Light output from the TFT array 16 is filtered by RGB pixel filter 18. The RGB pixel filter 18 may be comprised of a red filter layer, a green filter layer, and a blue filter layer. The layers may be deposited as thin films. As an example, the red filter layer contains an array of red light filter areas coinciding with the red pixel areas of the display. The remaining portions of the red filter are clear to allow other light to pass. Accordingly, the RGB pixel filter 18 provides a filter for each R, G, and B pixel in the display. The filters used in RGB pixel filter 18 depend on the wavelengths used in the light source.

A polarizing filter 24 only passes polarized light orthogonal to the light output from the polarizing filter 14. Therefore, the polarizing filter 24 only passes light that has been polarized by a non-energized pixel area in the liquid crystal layer 20 and absorbs light that passes through the energized portions of the liquid crystal layer 20. The magnitudes of the electric fields across the liquid crystal layer 20 controls the brightness of the individual R, G, and B components to create any color. In this manner, any color image may be presented to the viewer by selectively energizing the various transistors in the TFT array 16.

Other types of LCDs substitute a passive conductor grid for the TFT array 16, where energizing a particular row conductor and column conductor energizes a pixel area of the liquid crystal layer at the cross point. Other types of display systems use reflective "Digital Light Valves" (available from Texas Instruments) in place of LCDs to take light from a light source and create an image.

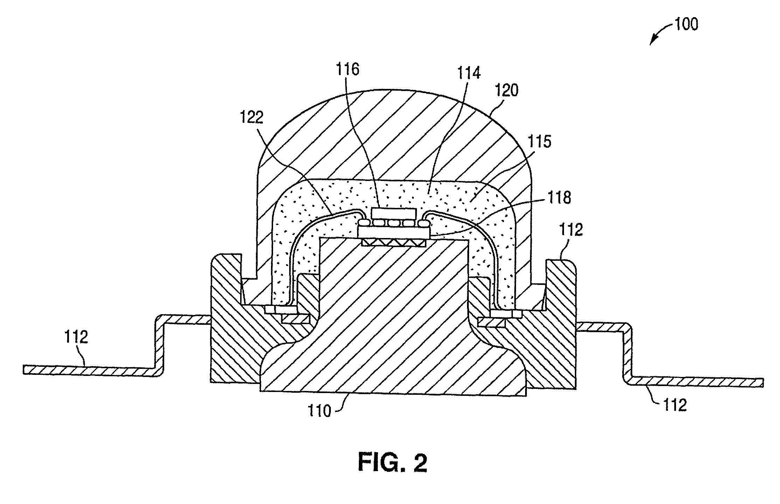

In accordance with embodiments of the invention, at least one of the LEDs in the backlight LED array is a wavelength-converted LEDs. In one embodiment, the wavelength-converted LEDs are the green light sources. In other embodiments, other light sources may be wavelength-converted LEDs. Fig. 2 illustrates an example of a packaged wavelength-converted green LED suitable for use in LCD 10 of Fig. 1. LED die 116, which may be, for example, a 111-nitride light emitting device, is mounted on a submount 118. The submount is supported by a pedestal 110 and is electrically connected to leads 112 by wires 122. A lens 120 covers LED die 116. The space 114 between LED die 116 and lens 120 is filled with a wavelength-converting material 115. The wavelength-converting material may be mixed with another material, such as silicone or epoxy, which has an index of refraction selected to maximize extraction of light from lens 120.

Fig. 3 illustrates an alternative embodiment of a wavelength converted green LED. 111-nitride n-type region 40, active region 38, and p-type region 36 are fabricated on a substrate such as SiC or sapphire. Contacts 34 are connected to n-type region 40 and p-type region 36. The device is mounted on a submount 30 with interconnects 32 which may be, for example, solder. A reasonable conformal wavelength-converting layer 44 is formed over the top and side surfaces of the LED. Wavelength-converting layer 44 may be formed by, for example, stenciling or electrophoretic deposition. Stenciling is described in "Stenciling Phosphor Coatings On Flip Chip Phosphor-LED Devices," U. S. Application Serial No. 09/688,053, and electrophoretic deposition is described in "Using Electrophoresis To Produce A Conformally Coated Phosphor-Converted Light Emitting Semiconductor Structure," U. S. Application Serial No. 09/879,627. Both applications are incorporated herein by reference. The device shown in Fig. 3 may be packaged in a package similar to that shown in Fig. 2. In some embodiments, the wavelength-converting material is located in an area of the package that is distant from the LED die, for example, as a coating on the inside or outside of lens 120, or within the material that forms lens 120, in order to reduce the amount of heat to which the wavelength-converting material is exposed.

Wavelength-converting material 115, 44 is selected to absorb the light emitted by the active region of the LED die and emit green light at a wavelength suitable for use in an LCD. The LED die may emit, for example, blue light having a wavelength between about 420 nm and about 460 nm. In other embodiments, the LED die may emit UV light, for example having a wavelength between about 380 nm and about 420 nm. In embodiments using a UV light LED, a UV filter may be positioned between the wavelength-converting material and the viewer to prevent UV light from exiting the system towards the viewer. Wavelength-converting material 115, 44 may be, for example, a strontium thiogallate phosphor, such as SrGa₂S₄:Eu²⁺ having a dominant wavelength of about 542 nm, a nitridosilicate phosphor, or any other suitable green-emitting phosphor.

The use of an LED die coated with a green-emitting phosphor as the green source in an LCD offers several advantages over the use of an LED die that directly emits green light. It is difficult to fabricate devices which emit exactly the same green color. Generally, green LEDs can range in color from bluish green to yellowish green. Variations in color between different green LEDs in a backlight for an LCD can lead to less saturated colors than would be possible if all LEDs emitted the same green color. Thus, each green LED used as a backlight must emit the same color. Selection of LEDs which emit the same color green light is expensive, as only a few of the green LEDs are useable. In addition, the color emitted by green LEDs can change with temperature and/or driving current. Temperature changes may cause variation in the viewing experience of the display because the color of the direct light changes with temperature and/or because the transmission of the color filters does not change with temperature in the same manner as the LED.

LEDs coated with green-emitting phosphors may eliminate the problems encountered with green LEDs. The green-emitting phosphor may be selected such that a relatively broad range of pump wavelengths will result in emission of green light, eliminating the need for each LED to emit the same color light, while preserving color uniformity in the display. In addition, the green-emitting phosphor may be selected for high temperature stability, such as SrGa₂S₄:Eu²⁺, eliminating temperature-induced variations in color.

Generally, the thickness of the wavelength-converting material surrounding or coating an LED is selected such that a portion of light emitted by the active region of the LED exits the wavelength-converting layer unconverted In order to completely convert the light emitted by the LED, the wavelength-converting layer must be thick, which can result in increased back-scattering of light in the wavelength-converting layer. Back-scattering increases the likelihood that light will be lost through absorption by semiconductor layers in the LED chip or other portions of the device, which can reduce the total lumen output of the device. Leakage of unconverted light from the active region of the LED mixes with the light emitted by the wavelength-converting material and changes the apparent color of light emitted by the device. In the LCD illustrated in Fig. 1, most leakage of unconverted light is filtered out by RGB pixel filter 18. The effect of leakage of unconverted light can also be minimized by selecting an LED that emits light that is either the same color as the blue LEDs used to make blue light in the backlight (for example, between about 440 nm and about 460 nm), or is such a short wavelength that it is barely visible to the human eye (for example, between about 420 nm and about 440 nm). Green phosphor-converted LEDs with the pump wavelength matched to the blue LEDs in the backlight or barely visible to the human eye may also be used in LCDs that do not require RGB pixel filters. Examples of such LCDs are described in "Backlight For A Color LCD," U. S. Application Serial No. 09/854,014, which is incorporated herein by reference.

Numerous issued patents describing light guides and LCDs provide techniques for improving light extraction efficiency, and any of these techniques may be employed, as appropriate, in the present invention. These patents include U.S. patent numbers 6,094,283; 6,079,838; 6,078,704; 6,073,034; 6,072,551; 6,060,727; 6,057,966; 5,975,711; 5,883,684; 5,857,761; 5,841,494; 5,580,932; 5,479,328; 5,404,277; 5,202,950; 5,050,946; 4,929,062; and 4,573,766, all incorporated herein by reference.

Having described the invention in detail, those skilled in the art will appreciate that, given the present disclosure, modifications may be made to the invention without departing from the spirit of the inventive concept described herein. Therefore, it is not intended that the scope of the invention be limited to the specific embodiments illustrated and described.

## Claims

1. A device comprising:
a backlight for a color display, the backlight comprising:
at least one red light source;
at least one blue light source; and
at least one green light source;
wherein at least one of the red, green, and blue light sources comprises a light emitting diode capable of emitting light at a first wavelength, and a wavelength-converting material disposed over the light emitting diode, the wavelength-converting material capable of absorbing light of the first wavelength and emitting light at a second wavelength.

2. The device of Claim 1 wherein the green light source comprises a light emitting diode capable of emitting light at the first wavelength, and the wavelength-converting material is capable of absorbing light of the first wavelength and emitting green light.

3. The device of Claim 2 wherein the first wavelength is between about 380 nm and about 460 nm.

4. The device of Claim 2 wherein the first wavelength is between about 420 nm and about 460 nm.

5. The device of Claim 2 wherein the wavelength-converting material is SrGa₂S₄:Eu²⁺.

6. The device of Claim 2 wherein the wavelength-converting material is a nitridosilicate phosphor.

7. The device of Claim 2 wherein the first wavelength is about the same as light emitted by the at least one blue light source.

8. The device of Claim 1 wherein the red light source comprises a light emitting diode capable of emitting light at the first wavelength, and the wavelength-converting material is capable of absorbing light of the first wavelength and emitting red light.

9. The device of Claim 1 wherein the blue light source comprises a light emitting diode capable of emitting light at the first wavelength, and the wavelength-converting material is capable of absorbing light of the first wavelength and emitting blue light.

10. The device of Claim 1 further comprising a mixing light guide capable of mixing light emitted by the at least one red light source, light emitted by the at least one blue light source, and the green light, such that the mixed light appears white.

11. The device of Claim 1 further comprising a homogenizing light guide.

12. The device of Claim 1 further comprising:
a first polarizing filter;
an energizing array;
an RGB pixel filter;
a liquid crystal layer; and
a second polarizing filter.

13. The device of Claim 12 wherein the first wavelength is filtered by a green pixel filter in the RGB pixel filter in a green pixel.

14. The device of Claim 1 wherein each of the at least one red light source and the at least one blue light source is a light emitting diode.

15. The device of Claim 1 wherein the wavelength-converting material coats a surface of the light emitting diode.

16. The device of Claim 1 wherein:
the at least one light source comprising a light emitting diode capable of emitting light at a first wavelength further comprises a lens; and
the wavelength-converting material is disposed between the lens and the light emitting diode.

17. The device of Claim 1 further comprising a filter disposed over the wavelength-converting material, wherein the filter absorbs or reflects a portion of the light of first wavelength.

18. A method performed by a color liquid crystal display, the display comprising a plurality of layers including a liquid crystal layer and a backlight comprising at least one red light emitting diode, at least one blue light emitting diode, and at least one green light source, the green light source comprising a light emitting diode capable of emitting light at a first wavelength, and a wavelength-converting material disposed over the light emitting diode, the wavelength-converting material capable of absorbing light of the first wavelength and emitting green light, the method comprising:
energizing the red light emitting diode;
energizing the blue light emitting diode;
energizing the light emitting diode capable of emitting light at a first wavelength such that the wavelength-converting material emits green light; and
selectively controlling the liquid crystal layer to display an image comprising a combination of red, blue, and green light.

19. The method of Claim 18 wherein said plurality of layers comprises a first polarizing filter, a thin film transistor array, the liquid crystal layer, and a second polarizing filter, wherein selectively controlling the liquid crystal layer comprises selectively activating transistors in the thin film transistor array.
